# EUROPEAN PATENT APPLICATION

(11) **EP 1 231 796 A2**
(43) Date of publication of application: **14.08.2002**
(21) Application number: 02250309.8
(22) Date of filing: 16.01.2002
(51) Int. Cl.: H04N 7/52

(54) **System and method for increased data capacity of a digital video link**

(30) Priority: 24.01.2001 US 263792 P; 14.02.2001 US 268840 P; 09.03.2001 US 274433 P; 12.09.2001 US 951289
(71) Applicant: Broadcom Corporation, Irvine, California 92618 (US)
(72) Inventor: Pasqualino, Christopher, Glendora, California 91741 (US); Bauch, Jeffrey S., Torrence, California 80503 (US); Petilli, Stephen, Pasadena, California 91108 (US)
(74) Representative: McLeish, Nicholas Alistair Maxwell

(57) **Abstract**

The present invention relates to a system and method for increasing the digital data capacity of a digital video link without increasing the pixel clock rate. The invention uses a shorter blanking period than the standard blanking period, in order to send more data over each channel of the digital video link. By shortening the vertical and horizontal blanking periods, the amount of time in each scan line available for sending data is increased. The inactive video portion of a scan line sent during vertical sync is also used to send auxiliary digital data, which could be additional channels of digital audio or other digital data. Shortening the blanking periods and using the inactive video sections of the scan lines add to the overall data capacity of the link and can be used to send other digital data, such as multi-channel audio, video, control, timing or other digital data

## Description

### CROSS REFERENCE TO RELATED APPLICATIONS

This application is related to, and claims benefit of and priority from Provisional Application No. 60/263,792 filed January 24, 2001, Provisional Application No. 60/268,840 filed February 14, 2001, and Provisional Application No. 60/274,433 filed March 9, 2001, the complete subject matter of each of which is hereby incorporated herein by reference in its entirety.

### BACKGROUND OF THE INVENTION

One embodiment of the present invention relates to increasing the amount of digital data capacity or throughput of a digital video link.

Typically digital video signals have a minimum of sixty frames of video per second. Each video frame is composed of horizontal scan lines, where the number of horizontal scan lines in a frame is dependent on the resolution of the system. Each horizontal scan line includes a blanking period followed by a series of digital video pixels. More specifically, the horizontal blanking period is used to send timing information. This consists of an HSync, comprised of a Front Porch, a Synchronization Pulse and a Back Porch. There is also typically a vsync (vertical sync) blanking period that is comprised of a Front Porch, a Synchronization Pulse and a Back Porch. The horizontal and vertical sync blanking periods take up to 30 to 40% of the total bandwidth is taken up by sync data.

Commercial applications utilizing Digital Visual Interface (hereinafter referred to as "DVI") standard frequently make significant use of existing VESA Computer Display standards. The sequence of timing and video data for particular display resolutions and timing is specified in the VESA Computer Display Monitor Timing standard, Version 1.0, Revision 0.8 dated September 17, 1998, incorporated herein by reference (hereinafter referred to as "DVI 1.0 specification"). A recent digital television standard is the CEA-EIA 861 standard for high speed digital interfaces, also incorporated herein by reference.

The DVI 1.0 specification identifies a high-speed digital connection, interface or link for visual data types that are display technology independent. In one example, the interface provides a connection between a computer and its display device. In another example, the interface provides a connection between a set top box and a DTV or HDTV. Such a DVI interface enables content to remain in the lossless digital domain from creation to consumption; display technology independence; plug and play through hot plug detection, EDID and DDC2B; and digital and analog support in a single connector.

One problem with commercial applications utilizing the DVI standard is that they do not provide for any transmission of digital audio data, let alone provide for the use of multiple audio channels or multiple audio streams. Another problem with such applications is that they do not provide for transmission of auxiliary digital data.

Further limitations and disadvantages of conventional and traditional approaches will become apparent to one of skill in the art, through comparison of such systems with the present invention as set forth in the remainder of the present application with reference to the drawings.

### BRIEF SUMMARY OF THE INVENTION

One embodiment of this invention uses abbreviated blanking periods, as compared to the standard VESA and CEA-EIA blanking periods, in order to send data over one or more channels of the digital video link. By shortening the blanking period, the amount of time available for sending data in each scan line is increased, enabling the system to send more data over each channel. The inactive video portion of a scan line sent during vertical sync may also be used to send auxiliary digital data. Shortening the blanking periods and/or using the inactive video sections of the horizontal scan lines adds to the overall data capacity of the link and may be used to send other digital data, such as multi-channel audio, video, control, timing, closed captioning or other digital data.

One embodiment of the present invention provides a processing system for increasing the digital data capacity of a digital video communications link. The system includes an assembly device (i.e., a FIFO circuit) adapted to assemble a plurality of digital data streams into a digital data stream, and a multiplexer adapted to multiplex the digital data stream with a line of video data. A receiver receives the multiplexed digital data stream and a de-multiplixer de-multiplexes or separates the multiplexed digital data stream.

In another embodiment, the present invention provides a system for increasing a digital data capacity of a digital video communications link. The system includes a DVI Transmitter Frame Re-formatter device for accepting video, audio and auxiliary data and combining the data into aggregate data compliant with a predetermined video timing standard and a DVI Receiver Frame Reformatter for receiving the aggregate data and splitting out the video, data and video data.

Yet another embodiment of the present invention provides a system for increasing the digital data capacity of a digital video communications link, wherein the data on the link is encrypted according to a High-bandwidth Digital Content Protection (HDCP) standard. The system includes a FIFO circuit for assembling a plurality of digital data streams into a digital data stream, and a multiplexer for multiplexing the digital data stream with a line of video data forming an aggregate data stream.

Yet still another embodiment of the present invention comprises a method for increasing the digital data capacity of a digital video communications link. The method comprises the steps of decreasing the duration of the blanking interval associated with a line of video data to a duration substantially less than industry standard blanking intervals, processing a plurality of digital data streams into a digital data stream, and multiplexing the digital data stream with a line of video data.

In still yet another embodiment, the present invention comprises a method for increasing the digital data capacity of a digital video communications link, wherein the data on the link is encrypted according to the HDCP standard. The method comprises the steps of decreasing the duration of the blanking interval associated with a line of video data to a duration substantially less than industry standard blanking intervals, processing a plurality of digital data streams into a digital data stream, and multiplexing the digital data stream with a line of video data.

Another embodiment of the present invention comprises a method for increasing the digital data capacity of a digital video communications link. The method comprises receiving information transmitted at a first timing standard collecting sync timing information for the received information, modifying the collected sync timing information, receiving the modified timing information transmitted with aggregate information, generating audio and auxiliary data from the received aggregate information, outputting the audio and auxiliary data as an audio and auxiliary stream, reconstructing the first timing standard, and outputting a video stream.

One embodiment of the present invention further comprises a method for increasing the digital data capacity of a digital video communications link wherein the data on the link is encrypted according to the HDCP standard. The method comprises transmitting information at a first timing standard; receiving the transmitted information; collecting sync timing information for the received information; modifying said sync timing information; multiplexing audio and auxiliary data onto a video stream forming aggregate information; transmitting the aggregate information with the modified sync timing; receiving the aggregate information with the modified timing; demultiplexing the aggregate information generating the audio and auxiliary data; outputting the audio and auxiliary data as an audio and auxiliary stream; reconstructing the first timing standard; and outputting the video stream.

Still another embodiment comprises a method for increasing the digital data capacity of a digital video communications link. The method comprises the steps of receiving digital information having timing in accordance with a first standard, modifying the timing of the digital information received, combining the digital information with additional digital information to form a composite digital data stream and transmitting said composite digital data stream with modified timing.

Additional features of the present invention, as well as details of an illustrated embodiment thereof, will be more fully understood from the following description and drawings, wherein like numerals refer to like parts.

### BRIEF DESCRIPTION OF SEVERAL VIEWS OF THE DRAWINGS

Fig. 1 illustrates a block diagram of an exemplary digital display link system;
Fig. 2 illustrates a timing diagram of a portion of a standard frame of digital video data;
Figs. 3A and 3B illustrate a flow diagram of one method of increasing digital data capacity in accordance with one embodiment of the present invention;
Fig 4 illustrates a block diagram of a digital display link system with increased digital data capacity in accordance with one embodiment of the present invention;
Fig 5 illustrates a block diagram of a digital display link system similar to that illustrated in Fig. 4 in accordance with one embodiment of the present invention;
Fig. 6 illustrates a timing diagram of the first line of a frame of digital data, with a reduced horizontal blanking interval and information for the reconstruction of vertical sync. in accordance with one embodiment of the present invention;
Fig. 7 illustrates a timing diagram of one of the lines corresponding to inactive video (auxiliary data) in a frame of digital data, with a reduced horizontal blanking interval in accordance with one embodiment of the present invention;
Fig. 8 illustrates a timing diagram of one of the lines corresponding to active video in a frame of digital data, with a reduced horizontal blanking interval, in accordance with one embodiment of the present invention;
Fig. 9 illustrates a two dimensional representation of a complete frame as constructed from the three types of lines illustrated in Figs. 6, 7 and 8 in accordance with one embodiment of the present invention;
Fig. 10 illustrates a block diagram of one embodiment of a FIFO buffer circuit used for assembling the audio streams into a single stream for transmission in the horizontal blanking periods in accordance with one embodiment of the present invention;
Fig. 11 illustrates a block diagram of one embodiment of a FIFO buffer circuit used for assembling the auxiliary streams into a single stream for transmission in the vertical blanking period in accordance with one embodiment of the present invention;
Fig. 12 illustrates a block diagram of one embodiment of a data stream multiplexer for multiplexing the digital audio, auxiliary digital data and digital video streams into a single digital stream for transmission across a DVI 1.0 in accordance with one embodiment of the present invention;
Fig. 13 illustrates a block diagram of a data stream demultiplexer for demultiplexing the single digital stream into the digital audio, auxiliary digital data and digital video streams in accordance with one embodiment of the present invention;
Fig. 14 illustrates a block diagram of a FIFO buffer circuit used for separating the single composite auxiliary data channel into its constituent data streams in accordance with one embodiment of the present invention; and
Fig. 15 illustrates a block diagram of a FIFO buffer circuit used for separating the single composite audio data channel into its constituent data streams in accordance with one embodiment of the present invention.

### DETAILED DESCRIPTION OF THE INVENTION

The present invention provides a system and method for incorporating additional digital channels over a DVI link. In one embodiment, multiple audio streams are transmitted over the DVI link. This includes the transmission of high quality, multi-channel audio over the DVI link, meeting the needs of the Consumer Electronics (hereinafter referred to as "CE) industry. It should be appreciated that the system and method provides for the transmission of other data channels over the link as well.

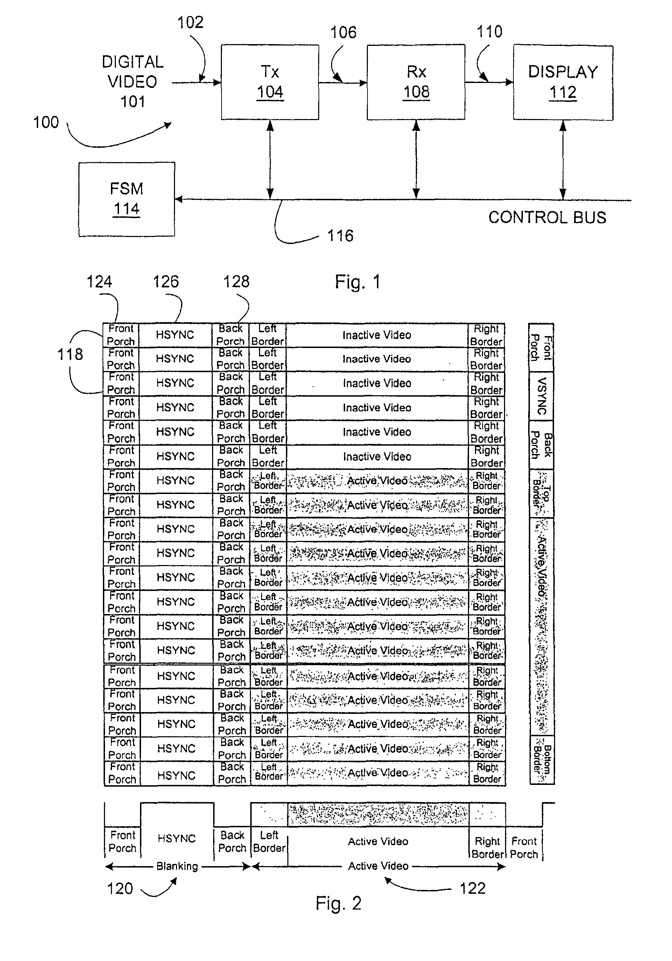

Fig. 1 illustrates a block diagram of an exemplary digital display link system, generally designated 100. In this embodiment, system 100 includes a digital video source 101 connected to a digital video transmitter 104 via input lines 102. Transmitter 104 encodes the digital video data for transmission over a digital display link 106. On the display side of the system, receiver 108 decodes the digital signal received from digital display link 106 and produces a digital video signal transmitted via output lines 110 to display 112. The overall operation of the system may be controlled, for example, by finite state machine 114 using control bus 116.

Generally, the typical digital video signal includes sixty frames of video per second. Of course, the frame rate can be much lower or higher than 60. For example, the range can be from 25 to 120 frames per second. A video frame is built up from or comprised of horizontal scan lines, where the number of horizontal lines in a frame is dependent on the resolution of the system. Fig. 2 illustrates a timing diagram of an abbreviated standard frame of digital video data, which, for example, may be transmitted via system 100 illustrated in Fig. 1.

Fig. 2 illustrates the basic elements of the standard video frame. Each horizontal scan line 118 includes a blanking period or sync 120 followed by a series of digital video pixels 122. The horizontal blanking period or sync is used to send timing information and is comprised of three elements: a Front Porch 124, an HSYNC or synchronization pulse 126 and a back porch 128. It should be appreciated that the sync pulse 126 can be either positive or negative. The sequence of video timing and video data is specified in the VESA and CEA-EIA standards referenced above. The VESA Computer Display standard is used by digital video links such as DVI links. An exemplary DVI link has three serial channels for RGB video data and a clock channel.

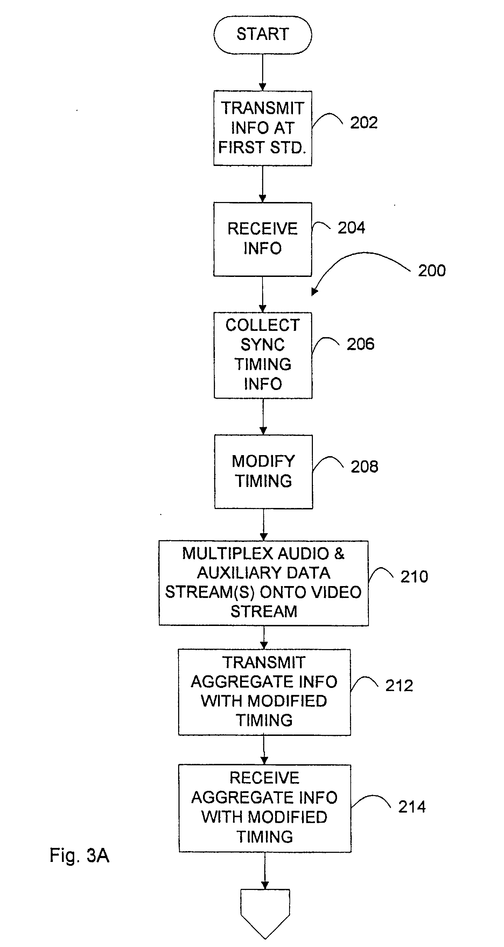

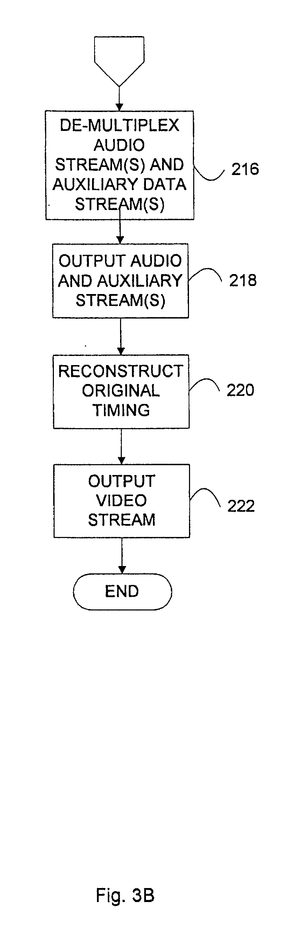

Figs. 3A and 3B provide an overview of one method of increasing digital data capacity in accordance with one embodiment of the present invention. In one example the illustrated method may be used to increase the digital data capacity of a digital video communications link wherein the data on the link is encrypted according to the High-bandwidth Digital Content Protection (hereinafter referred to as an "HDCP") standard.

The illustrated method 200 starts, transmitting information at a first timing standard as illustrated by block 202. The transmitted information is received as illustrated by block 204, sync timing information about the received information is collected as illustrated by block 206 and the collected timing information is modified a as illustrated by block 208. Audio and auxiliary data are multiplexed along with video data onto a video stream, forming aggregate information, and transmitted with the modified timing as illustrated by blocks 210 and 212 respectively.

The aggregate information, with the modified sync timing, is received as illustrated by block 214 and demultiplexed as illustrated by block 216. Demultiplexing the aggregate information reconstructs or regenerates the audio and auxiliary data. The audio and auxiliary data is output as an audio and auxiliary stream as illustrated by block 218. The first timing standard is reconstructed and a video stream is output at the first timing standard as illustrated by blocks 220 and 222, respectively.

One embodiment of a digital display link system for increasing digital data capacity includes a DVI Transmitter Frame Re-formatter communicating with a DVI Receiver Frame Reformatter. The DVI Transmitter Frame Reformatter accepts video data, audio data and auxiliary data and combines the data into aggregate data or frame analogous to a current video timing standard. This frame is then output to the DVI transmitter. On the receiving side a DVI receiver provides the aggregate data to a DVI Receiver Frame Reformatter. The DVI Receiver Frame Reformatter splits out the auxiliary, audio and video data.

The standard video frame (i.e., video timing standard) is any current standard compatible with currently available displays. A representation of a standard video frame is diagrammed in Fig.2. The names for various parameters used are intended to be the same as used by the VESA timing standards. The diagram is organized such that the HSYNC signal occurs on the left side of the diagram and the VSYNC signal occurs at the top. This is done to support the HDCP encryption.

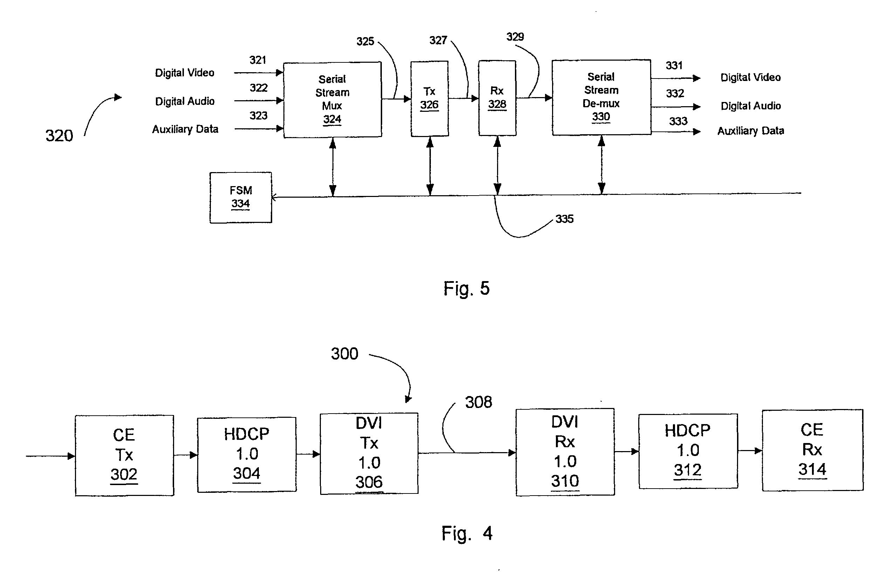

A block diagram of one embodiment of a digital display link system with increased digital data capacity, generally designated 300, is illustrated in Fig. 4. In this embodiment, the system 300 increases the digital data capacity of a digital video communications link wherein the data on the link is encrypted according to the HDCP standard.

In this embodiment, system 300 includes a DVI CE transmitter 302 that transmits information at a first timing standard to a HDCP engine or device 304. In this embodiment, all inputs to the system 300 may be compliant with the requirements of the DVI 1.0 specification. The system 300 accepts a single stream of video data, from 0 to 8 streams of audio data, and from 0 to 4 streams of auxiliary data. In one embodiment, the audio rate for all active audio channels is identical as inputs. Similarly, the auxiliary data rate for all active auxiliary channels may be identical. It should be appreciated that the auxiliary rates and audio rates need not be the same. Furthermore, auxiliary channels, as well as audio channels, can each have different rates.

It should be appreciated that the audio input formats may be any digital audio format. The current embodiment specifies Unformatted Audio Data, SPDIF, or DVD Audio. It is anticipated that other audio formats will be developed. For any input standard that encodes a clock onto the data (i.e. SPDIF Uses Bi-Phase Mark Encoding for much of the transmitted data), an Audio Input Interface layer must be utilized remove the clock component to conserve link bandwidth. This encoding shall be re-applied by the receiver to reproduce the data format provided to the transmitter system.

The HDCP engine 304 encrypts or transforms the information according to an HDCP standard 1.0. In one embodiment, the HDCP engine 304 receives the transmitted information and encrypts it. In another embodiment, the HDCP engine 304 can be omitted. A DVI transmitter 306 communicates with the HDCP engine 304. The DVI transmitter 306 transmits the video, audio and auxiliary data stream (with optional encryption) to the DVI receiver 310 via a digital video communications or DVI link 308. While the HDCP engine 304 and DVI transmitter 306 are illustrated as separate devices, it should be appreciated that a DVI transmitter with an integrated HDCP encryption engine is also contemplated.

The DVI receiver 310 communicates the aggregate information, with the modified sync timing, to a HDCP decryption engine or device 312, where the information is decrypted or reformed (i.e., transformed) according to an HDCP 1.0 standard. In one embodiment, the multiplexed unencrypted data is communicated to a DVI CE receiver 314, where it is demultiplexed and output as independent video, audio and auxiliary data streams. The timing input to the CE transmitter 302 is reproduced, and the video stream is also output. While the HDCP decryption engine 312 and DVI receiver 314 are illustrated as separate devices, it should be appreciated that a DVI receiver with an integrated HDCP encryption engine is also contemplated.

A detailed block diagram of one embodiment of a digital display system 320, similar to system 300, is illustrated in Fig. 5. Incoming streams of video 321, audio 322 and auxiliary data 323 are assembled together by stream multiplexer 324, generating a digital data stream 325. In one embodiment, a transmitter, similar to transmitter 302 illustrated in Fig. 4, transmits digital video, audio and auxiliary data, for example, to the serial stream multiplexer 324.

The data stream 325 is encoded and transmitted by the video link transmitter 326 over the display link 327. The display link receiver 328 receives the data stream 327 and decodes the signals, recovering the original data and converts it into data 329. A serial stream demultiplexer 330 receives the data 329 from receiver 328 and demultiplexes the data 329 into digital video stream 331, digital audio 332 and auxiliary digital data 333, for example. In one embodiment, the overall operation of the system 320 may be controlled by finite state machine 334 using control bus 335 for example. The digital data multiplexed in Fig. 5 illustrates one embodiment of the invention. Those skilled in the art will recognize that this subject invention may transmit various kinds of digital data over the digital video link using the increased digital capacity of this invention.

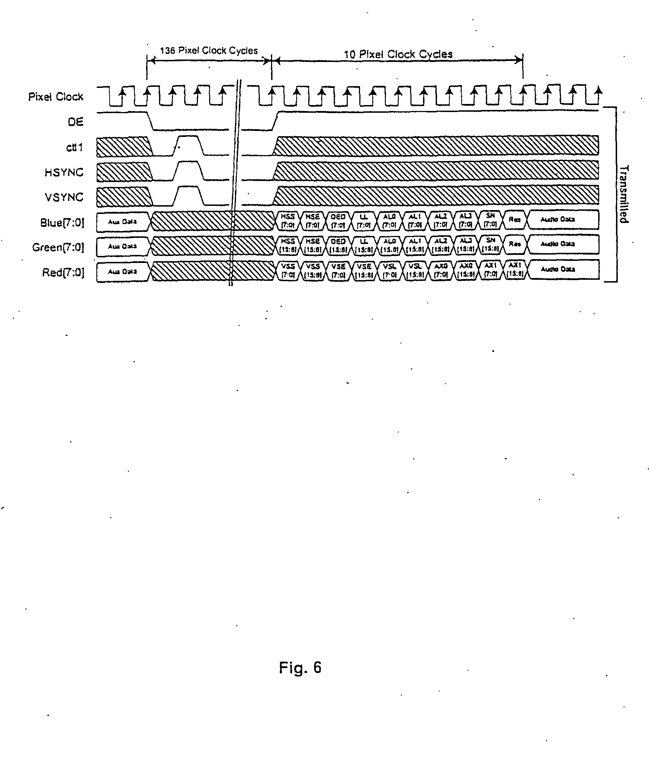

A timing diagram of the first line of a frame of digital data, in accordance with one embodiment of the invention is illustrated in Fig. 6, which provides one horizontal and one vertical sync (i.e., modified Vsync). In this illustrated embodiment, the entire sync period precedes the actual video portion of the frame. It should be appreciated that the illustrated line includes a reduced horizontal and vertical blanking intervals, which enables audio data to be transmitted after the shorter blanking intervals. When a vertical blanking interval is sent in a scan line, the section of the scan line that normally contains video data is inactive. The inactive video portion of a scan line is used to transmit auxiliary digital data. In one embodiment, additional channels of digital audio or other digital data are transmitted.

Three separate channels: Blue, Green and Red are illustrated in Fig. 6. In this embodiment, each of these channels has a reduced horizontal blanking period that can be used to transmit other data, such as digital audio data, etc.

The duration of the Data Enable pulse (hereinafter referred to as "DE") during vertical sync is intended to support the HDCP frame key recalculation operation. This operation generally requires that DE be asserted no sooner than 128 clock cycles after the assertion of ctl3. In general ctl3 should be de-asserted prior to the de-assertion of DE, and remain de-asserted for at least 8 clock cycles prior to the assertion of ctl3. This indicates, for this embodiment, a minimum blanking period of 136 clock cycles. Fig. 6 illustrates that ctl1 (which is optional) is active during the VSYNC pulse. Further, a modified DE pulse is defined as, for example, a minimum of 64 cycles long to support HDCP

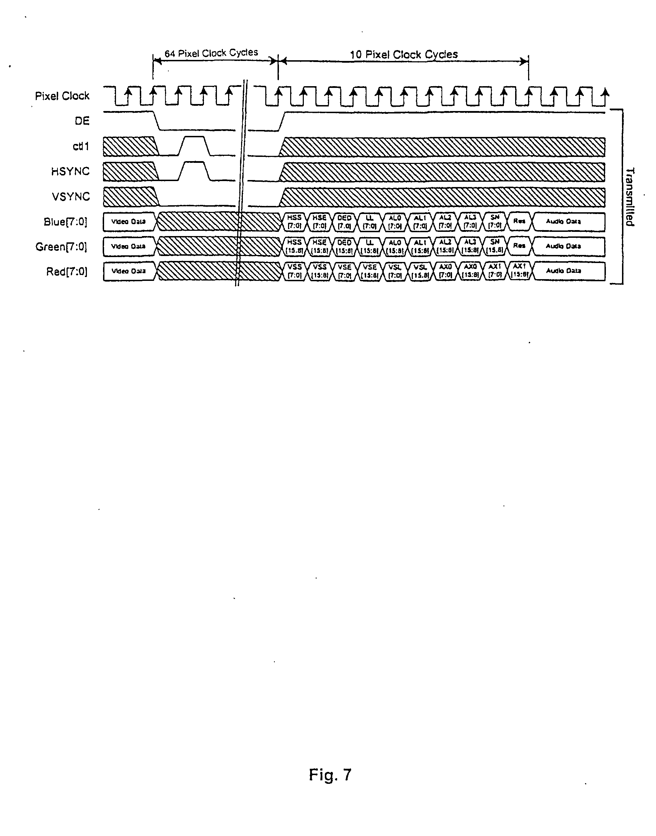

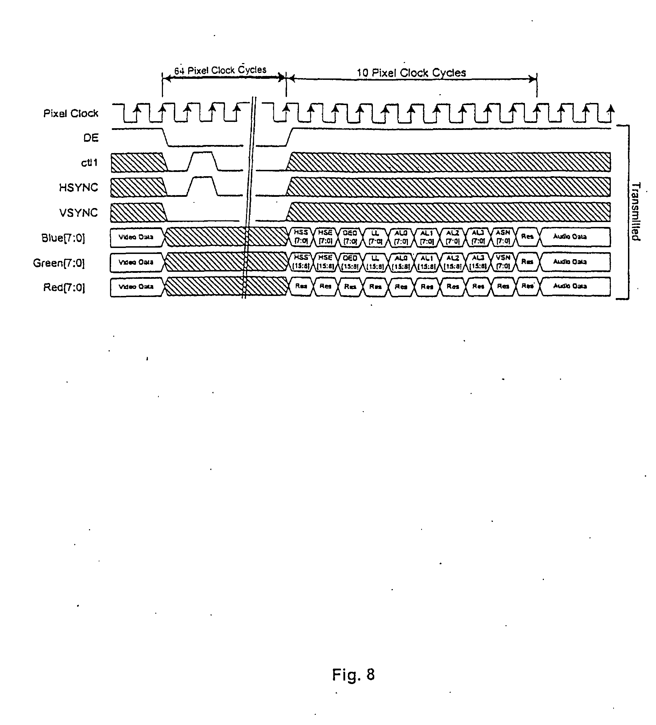

Fig. 6 illustrates that the Vsync and Hsync pulses occur simultaneously. The duration of the Vsync pulse is intended to support the raising of ctl3 for 9 clock cycles. In the illustrated timing diagrams (and the following Figs. 7 and 8) HSS represents the Horizontal Sync Start, which in the case of active video, are the pixels after the falling edge of the DE pulse); HSE represents the horizontal sync end, which in the case of active video, are the pixels after the falling edge of DE; DED represents DE duration, which in the case of active video, are the pixels after the falling edge of DE when DE goes back high; LL represents line length including the front porch + sync + back porch + left border + data + right border; AL0 represents the Audio Channel 0 byte count for a specified audio line; AL1 represents the Audio Channel 1 byte count for a specified audio line; AL2 represents the Audio Channel 2 byte count for a specified audio line; AL3 represents the Audio Channel 3 byte count for a specified audio line; SN represents the Frame Serial Number which s the same number for the entire frame; VSS represents the Vertical Sync Start which are the lines into the vertical blanking period that the Vsync changes state; VSE represents the Vertical Sync End which is the lines in the vertical blanking period that the Vsync changes state again; VSL represents the Vertical Sync Lines which is a duration, in lines of the vertical front porch, sync pulse and back porch; AX0 represents an Auxiliary Data channel 0 byte count for an auxiliary line; and AX1 represents Auxiliary Data Channel 1 which is the byte count for an auxiliary line.

In one embodiment, the Hsync pulse transitions before the 136 clock cycle modified Hsync period completes. In other words, DE goes high before the sync start information can be relayed. In these instances, the Hsync edge should transition at the normal time and the remainder of the pulse will be defined by the transmitted information. The Hsync will have second transition prior to completion of the 136 clock cycle modified Hsync period. In this embodiment, the sync pulse should be normal.

Fig. 7 illustrates a timing diagram of one of the lines corresponding to inactive video (i.e., modified Hsync auxiliary timing) in a frame of digital data with a reduced horizontal blanking interval according to one embodiment of the invention. Fig. 7 specifies parameters that describe one horizontal sync. The normally inactive video portion of a scan line may be used to send auxiliary digital data, which could include additional digital audio or other data.

Fig. 8 illustrates a timing diagram of one of the lines corresponding to active video (i.e., modified Hsync video timing) in a frame of digital data, with a reduced horizontal blanking interval according to one embodiment of the invention. Fig. 8 specifies parameters that describe one Hsync. This reduced horizontal blanking period enables audio data to be transmitted after the shorter blanking period and before the video data is sent.

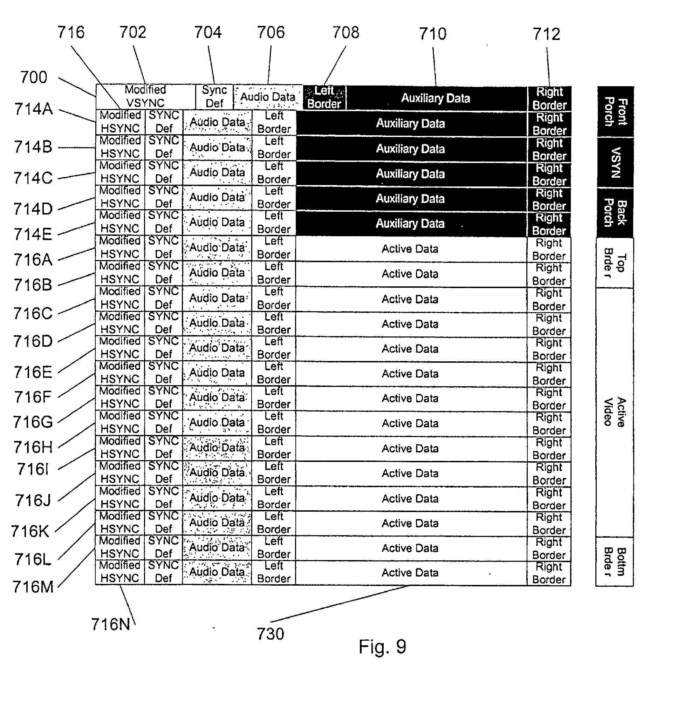

Fig. 9 illustrates a two dimensional representation of a complete video frame of digital data constructed from the three types of lines described in Figs. 6, 7 and 8 according to one embodiment of the invention. The modified Vsync illustrated in Fig. 6 is represented as line 700 of the complete frame of digital data illustrated Fig. 9. Line 700 includes a modified Vsync 702, Sync definition 704, audio data 706, left border 708, auxiliary data 710 and a right border 712.

The modified Hsync auxiliary timing illustrated in Fig. 7 is represented as lines 2-6, generally designated 714A through 714E, of the complete frame of digital data illustrated in Fig. 9. Each of these lines includes the modified Hsync 716, Sync definition 704, audio data 706, left border 708, auxiliary data 710 and right border 712. It should be appreciated that the front and back porch illustrated in Fig. 2 are eliminated for each line 714A through 714E. In this embodiment Hsync is replaced with the modified Hsync 716 and Sync definition data is included.

Fig. 9 also illustrates the modified H-sync active video timing of Fig. 8. The Hsync active video timing is represented as lines 7-19 of the complete frame of digital data, generally designated 718 A-N. Each of these lines includes modified Hsync 716, sync definition data 704, audio data 706, left border 708, active video 730 and right border 712. Again, it should be appreciated that the front porch and back porch of the frame illustrated in Fig, 2 are eliminated and that H-sync is replaced with modified H-sync and sync definition data.

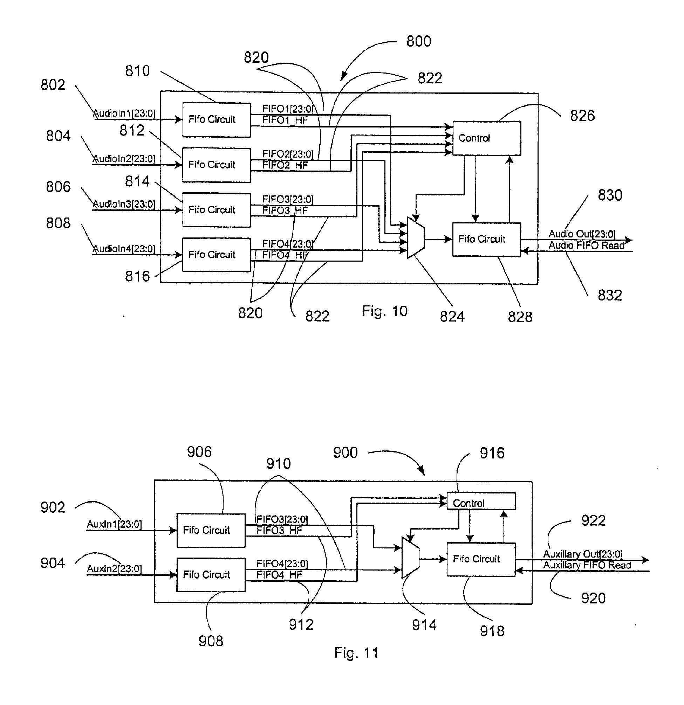

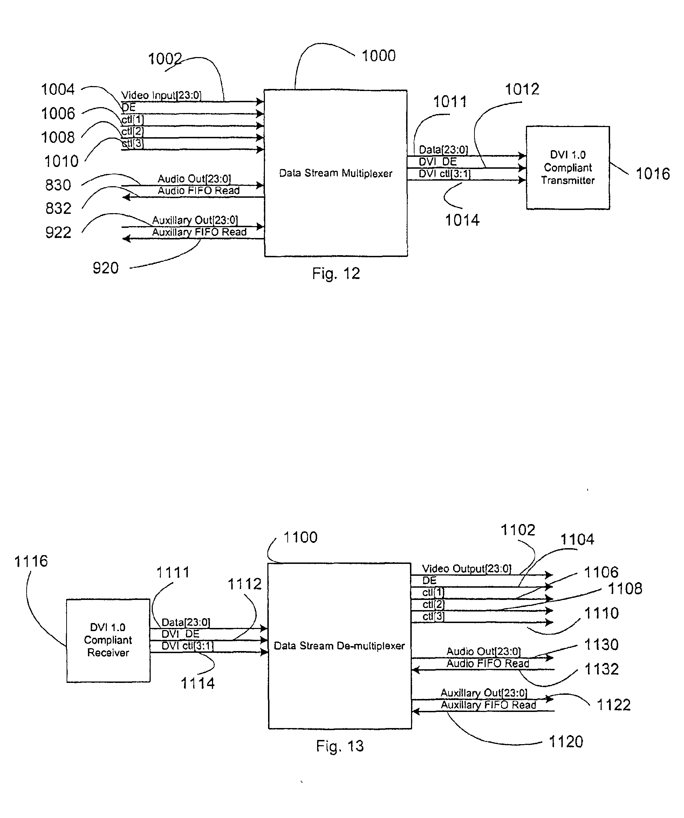

Fig. 10 is a block diagram of one embodiment of a FIFO buffer circuit 800 used in one embodiment for assembling the audio streams into a single stream for transmission in the horizontal blanking periods. In this embodiment, four channels of 24 bit digital audio date are assembled into a single stream. Four audio inputs, Audioln1 802, Audioln2 804, Audioln3 806, Audloin4 808 are illustrated as inputs to FIFO circuits 810, 812, 814 and 816 respectively. Each of the FIFO circuits has two outputs, FIFO1 820 and FIFO1_HF 822. For example, FIFO Circuit 810 has FIFO1 and FIFO1_HF outputs 820 and 822, while FIFO circuit 816 has a FIFO4 and FIFO4_HF outputs 820 and 822 as illustrated. Each of the FIFO outputs 820 are communicated to a multiplixer 824 while each of the FIFO_HF outputs 822 are communicated to a control 826 communicating with the FIFO circuit 828 and multiplexer 824. FIFO circuit 828 receives an output of the multiplexer 824 as its input. Audio FIFO Read 832 is communicated to the FIFO Circuit 828 and Auxiliary Out 830 is output to the Data Stream Multiplexer illustrated in Fig. 12

In this embodiment, each audio link supports data at rates of at least 3.1Mbps. It is contemplated this rate may be exceeded, however the throughput of all combined channels must not exceed the maximum available audio bandwidth.

Fig. 11 illustrates a block diagram of one embodiment of a FIFO buffer circuit 900 used to assemble the auxiliary streams into a single stream for transmission in the vertical blanking period. In one embodiment, two channels of 24 bit auxiliary data Auxln1 902 and Auxln2 904 are illustrated being assembled into a single stream. The FIFO buffer circuit 900 includes two FIFO circuits 906 and 908 having Auxln1 902 and Auxln2 904 as inputs. Of course, any number of audio or auxiliary channels may be used.

Each of the FIFO circuits has two outputs, FIFO 910 and FIFO_HF 912. For example, FIFO Circuit 906 has a FIFO3 and FIFO3_HF outputs 910 and 912, while FIFO circuit 908 has a FIFO4 and FIFO4_HF outputs 910 and 912 as illustrated. Each of the FIFO outputs 910 are communicated to a multiplixer 914 while each of the FIFO_HF outputs 912 are communicated to a control 916 communicating with a third FIFO circuit 918. FIFO circuit 918 receives an output from the multiplexer 914 as an input. Auxiliary FIFO Read 920 is communicated to the FIFO Circuit 918 and Auxiliary Out 922 is output to the Data Stream Multiplexer illustrated in Fig. 12. It should be appreciated that, in one embodiment, the throughput of the combined auxiliary channels does not exceed the maximum available auxiliary bandwidth. In addition, the auxiliary bandwidth may be defined as the traditional vsync blanking period less the hsync portion of this blanking period, as shown in Fig. 9.

Fig. 12 illustrates a block diagram of one embodiment of a data stream multiplexer, generally designated 1000, for multiplexing the digital audio, auxiliary digital data and digital video streams into a single digital stream for transmission across a DVI link. In this embodiment, the multiplexer multiplexes a video input 1002, DE 1004, ctl[1] 1006, ctl[2] 1008 and ctl[3] 1010. In addition, the audio out 830 and auxiliary out 922 are input and the Audio FIFO Read 832 and Auxiliary FIFO Read 920 are communicated to the FIFO buffer circuits 800 and 900 respectively as illustrated. The Data Stream Multiplexer 1000 outputs data 1011, DVI_DE 1012 and DVI ctl 1014 to a DVI compliant transmitter 1016. The DVI compliant transmitter in turn transmits this data to the receiving side illustrated in Figs 13, 14 and 15.

Fig. 13 illustrates a block diagram of one embodiment of a data stream demultiplexer, generally designated 1100 for demultiplexing the single digital stream into the digital audio, auxiliary digital data and digital video streams. This device performs the inverse functions of the multiplexer illustrated in Fig. 12.

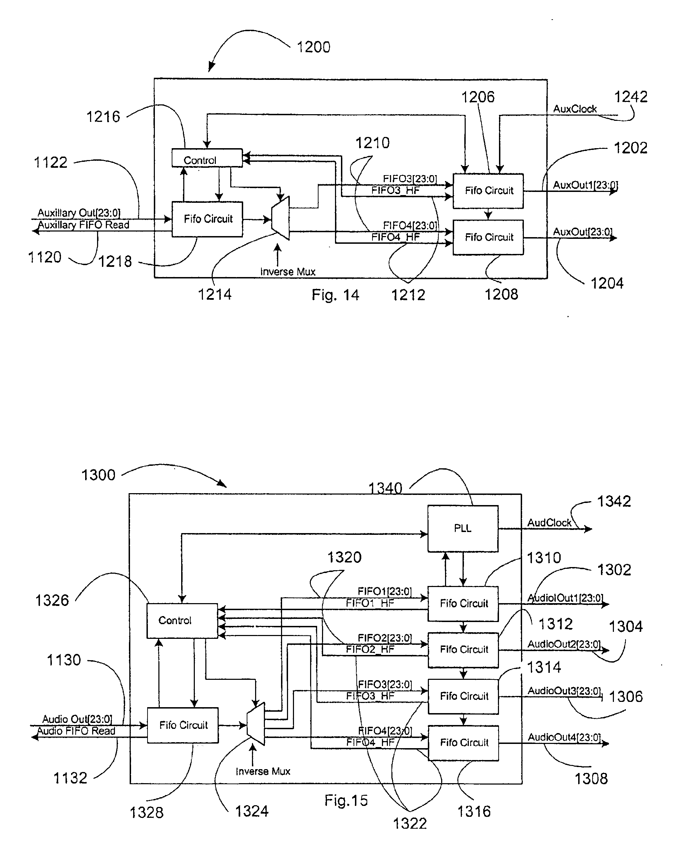

A DVI compliant receiver 1116 receives or acquires the data transmitted by the DVI compliant transmitter 1016. In this embodiment, the receiver 1116 outputs data 1110, DVI_DE 1112 and DVI ctl 1114 to the Data Stream Demultiplexer 1100. The Data Stream Demultiplexer 1100 demultiplexes or separates such data into video output 1102, DE 1104, ctl[1] 1106, ctl[2] 1108 and ctl[3] 1108. In addition, the Data stream demultiplexer 1100 outputs Audio Out 1130 and Auxiliary Out 1122, Audio FIFO Read 1132 and Auxiliary FIFO Read 1120 are communicated to and from the FIFO buffer circuits illustrated in Figs 14 and 15. It should be appreciated that, in one embodiment, Audio Out 1130, Auxiliary Out 1122, Audio FIFO Read 1132 and Auxiliary FIFO Read 1120 are substantially similar to, if not the same as, Audio Out 830, Auxiliary Out 922, Audio FIFO Read 832 and Auxiliary FIFO Read 920 discussed previously.

Fig. 14 illustrates a block diagram of a FIFO buffer circuit, generally designated 1200, used for separating the single composite auxiliary data channel into its constituent data streams. In one embodiment, this circuit performs the inverse function of the circuit illustrated in Fig. 11. In the illustrated embodiment, Auxiliary Out 1122 is separated into two channels of 24 bit auxiliary data AuxOut1 1202 and AuxOut 1204. The FIFO buffer circuit 1200 includes a FIFO circuit 1218 that receives Auxiliary Out 1122 as an input and outputs Auxiliary FIFO Read 1120.

The FIFO Circuit 1218 communicates with an inverse multiplexer 1214 and a control 1216 that in turn communicates with the inverse multiplexer 1214. The control 1216 communicates with two FIFO Circuits 1206 and 1204 and a clock recovery device, outputting an AUXClock signal 1242. Of course, several clock recovery PLL's may be used to support multiple auxiliary and audio data rates

Each of the FIFO circuits 1206 and 1208 has two inputs, FIFO 1210 and FIFO_HF 1212, where FIFO 1210 is communicated by the inverse multiplexer 1214 and FIF_HF is communicated by the control 1216. For example, FIFO Circuit 1206 has a FIFO3 and FIFO3_HF inputs 1210 and 1212, while FIFO circuit 1208 has a FIFO4 and FIFO4_HF inputs 1210 and 1212 as illustrated. Each of the FIFO circuits has one output, where FIFO circuit 1206 outputs AuxOut1 1202 while FIFO Circuit 1208 outputs AuxOut 1204 as illustrated.

Fig. 15 is a block diagram of a FIFO buffer circuit 1300 used for separating the single composite audio data channel into its constituent data streams. This in the inverse function of the system illustrated in Fig. 10. In the illustrated embodiment, AudioOut 1130 is separated into AudioOut1 1302, AudioOut2 1304, AudioOut3 1306 and AudioOut4 1308. The FIFO buffer circuit 1300 includes a FIFO circuit 1228 that receives AudioOut 1130 as an input and outputs Audio FIFO Read 1132.

The FIFO Circuit 1328 communicates with a inverse multiplexer 1324 and a control 1326 which outputs a signal to an inverse multiplexer 1324. The control 1326 communicates with four FIFO Circuits 1310, 1312, 1314 and 1316 and PLL 1340 outputting an AudioClock signal 1342. In addition, the FIFO circuit communicates with the inverse multiplexer 1324.

As illustrated, control 1326 communicates with the FIFO circuits using FIFO_HF 1322 signals as illustrated. In addition, the inverse multiplexer 1324 communicates with each of the FIFO circuits using FIFO signals 1320, and the FIFO circuits communicate with each other as illustrated.

Many modifications and variations of the present invention are possible in light of the above teachings. Thus, it is to be understood that, within the scope of the appended claims, the invention may be practiced otherwise than as described hereinabove.

## Claims

1. A processing system for increasing the digital data capacity of a digital video communications link, comprising:
an assembly device adapted to assemble a plurality of digital data streams into a digital data stream, and
a multiplexer adapted to multiplex the digital data stream with a line of video data forming a aggregate digital data stream.

2. The system of claim 1, wherein said multiplexer multiplexes a digital audio data stream with said line of video data.

3. The system of Claim 1, where said assembly device is a FIFO circuit.

4. The system of Claim 1, including a transmitter adapted to transmit said multiplexed digital data stream.

5. The system of Claim 1, including a receiver adapted to receive said multiplexed digital data stream.

6. The system of Claim 1, including a de-multiplixer adapted to demultiplex said multiplexed digital data stream.

7. A system for increasing a digital data capacity of a digital video communications link, said system comprising:
means for accepting video, audio and auxiliary data and combining said data into aggregate data compliant with a predetermined video timing standard; and
means for acquiring said aggregate data and splitting out said video, data and video data.

8. The system of Claim 7, wherein said accepting means comprises a DVI Transmitter Frame Re-formatter.

9. The system of Claim 7, including means communicating with said acquiring means for transmitting said aggregate data.

10. The system of Claim 9, wherein said transmitting means comprises a transmitter.

11. The system of Claim 7, wherein said acquiring means comprises a DVI Receiver Frame Reformatter.

12. The system of Claim 7, including means communicating with said acquiring means for receiving said aggregate data.

13. The system of Claim 12, wherein said receiving means comprises a receiver.

14. A system for increasing the digital data capacity of a digital video communications link, wherein the data on the link is encrypted according to the High-bandwidth Digital Content Protection (HDCP) standard, and comprising:
a FIFO circuit for assembling a plurality of digital data streams into a digital data stream, and
a multiplexer for multiplexing the digital data stream with a line of video data forming an aggregate data stream.

15. A method for increasing the digital data capacity of a digital video communications link, comprising the steps of:
decreasing the duration of the blanking interval associated with a line of video data to a duration substantially less than industry standard blanking intervals;
processing a plurality of digital data streams into a digital data stream; and
multiplexing the digital data stream with a line of video data.

16. A method for increasing the digital data capacity of a digital video communications link, wherein the data on the link is encrypted according to the High-bandwidth Digital Content Protection (HDCP) standard, and comprising the steps of:
decreasing the duration of the blanking interval associated with a line of video data to a duration substantially less than industry standard blanking intervals;
processing a plurality of digital data streams into a digital data stream; and
multiplexing the digital data stream with a line of video data.

17. A method for increasing the digital data capacity of a digital video communications link, said method comprising the steps of:
receiving information transmitted at a first timing standard;
collecting sync timing information for said received information;
modifying said collected sync timing information;
receiving said modified timing information transmitted with aggregate information;
generating audio and auxiliary data from said received aggregate information;
outputting said audio and auxiliary data as an audio and auxiliary stream;
reconstructing said first timing standard; and
outputting a video stream.

18. The method as recited by claim 17, including transmitting said information at said first timing standard.

19. A method for increasing the digital data capacity of a digital video communications link wherein the data on the link is encrypted according to the High-bandwidth Digital Content Protection (HDCP) standard, said method comprising the steps of:
transmitting information at a first timing standard;
receiving said transmitted information;
collecting sync timing information for said received information;
modifying said sync timing information;
multiplexing audio and auxiliary data onto a video stream forming aggregate information;
transmitting said aggregate information with said modified sync timing;
receiving said aggregate information with said modified timing;
demultiplexing said aggregate information generating said audio and auxiliary data;
outputting said audio and auxiliary data as an audio and auxiliary stream;
reconstructing said first timing standard; and
outputting said video stream.

20. A method for increasing the digital data capacity of a digital video communications link, said method comprising the steps of:
receiving digital information having timing in accordance with a first standard;
modifying said timing of said digital information received;
combining said digital information with additional digital information to form a composite digital data stream; and
transmitting said composite digital data stream with modified timing.

21. The method of Claim 20, including receiving said composite digital data stream.

22. The method of Claim 21, including pulling out said digital information and said additional digital information.

23. The method of Claim 22, including regenerating first timing information for said digital information.

24. The method of Claim 20, wherein said digital information comprised video data.

25. The method of Claim 20, wherein said additional information comprises one of audio and auxiliary data.
